# EUROPEAN PATENT APPLICATION

(11) **EP 4 844 419 A1**
(43) Date of publication of application: **25.11.2026**
(21) Application number: 26157738.1
(22) Date of filing: 11.02.2026
(51) Int. Cl.: G01R 31/12

(54) **PREVENTIVE DIAGNOSIS APPARATUS AND METHOD FOR SUBSTATION EQUIPMENT**

(30) Priority: 23.05.2025 KR 20250067211
(71) Applicant: Korea Electric Power Corporation, Naju-si, Jeollanam-do 58322 (KR)
(72) Inventor: LEE, Wan Sock, 58322 Jeollanam-do (KR); YEO, Geun Taek, 58322 Jeollanam-do (KR); PARK, Hee Young, 58322 Jeollanam-do (KR); KIM, Jin Woo, 58322 Jeollanam-do (KR)
(74) Representative: Zacco Sweden AB

(57) **Abstract**

The present invention relates to a preventive diagnosis apparatus and method for substation equipment, and the preventive diagnosis apparatus for substation equipment includes a data collection module, a user interface, a database, and a processor operatively coupled to the data collection module, the user interface, and the database, wherein the processor stores complex data of substation equipment collected through the data collection module in the database, comprehensively determines a state of the substation equipment to provide a diagnosis result and history information, determines a partial discharge state using a partial discharge state determination algorithm on the basis of partial discharge data of the substation equipment, determines an insulation degradation state of the substation equipment using an insulation degradation state determination algorithm on the basis of insulation degradation data, and provides a comprehensive diagnosis result through the user interface.

## Description

### BACKGROUND

### 1. Field of the Invention

The present invention relates to a preventive diagnosis apparatus and method for substation equipment, and more particularly, to a preventive diagnosis apparatus and method for substation equipment, which may more precisely determine an abnormal sign of equipment based on a state determination algorithm in which maintenance and operation data are combined in addition to sensor data of substation equipment and may encompass not only preventive diagnosis but also maintenance and repair work.

### 2. Discussion of Related Art

In general, substation equipment is key infrastructure that convert and distributes high-voltage power, and as the importance of technology for monitoring a state of equipment in real time and preventing failures for stable power supply increases, preventive diagnosis systems for substation equipment have been introduced. Among them, a substation equipment diagnostic & analysis system (SEDA; substation preventive diagnosis solution) is used as a system that collects data in real time by attaching sensors to transformers and switchgears of 154 kV or higher and determines a state of equipment on the basis of the data.

This SEDA system was mainly applied to transformers and switchgears of 154 kV or higher and is configured to determine a state grade through criteria set according to diagnostic factors for each piece of equipment.

Further, the SEDA system was designed to support preventive diagnostics to enable early detection of abnormal symptoms in equipment and mainly determines the state of equipment on the basis of specific sensor-based data such as partial discharge, gas in oil, and on-load tap changer (OLTC) operation characteristics.

The related art of the present invention is disclosed in Korean Laid-open Patent Publication No. 10-2023-0105547 (published on July 11, 2023).

### SUMMARY OF THE INVENTION

Such conventional SEDA systems were applied only to some pieces of core equipment, preventive diagnosis was not performed on 25.8 kV class gas insulated switchgear (GIS) and other medium-low voltage system equipment with high failure frequency, and thus there was a limitation in failure preventing in the entire substation equipment. Further, diagnostic target data is limited to sensor-based data and does not reflect various types of data such as a maintenance history and operational information of equipment, and thus there was a problem that it is difficult to comprehensively and precisely evaluate a state of the equipment.

In addition, the conventional systems were structured around preventive diagnosis and thus had low usability in practical work such as maintenance and repair and lacked the connectivity and integration of equipment management tasks based on diagnostic results. In particular, there was a lack of linkage with main data required for maintenance practices, such as failure history information, supervisory control and data acquisition (SCADA) operation information, etc., and thus there was a limitation to its field usability.

The present invention is directed to solving the above problems and providing a preventive diagnosis apparatus and method for substation equipment, which may more precisely determine an abnormal sign of equipment based on a state determination algorithm in which maintenance and operation data are combined in addition to sensor data of substation equipment and may encompass not only preventive diagnosis but also maintenance and repair work.

According to an aspect of the present invention, there is provided a preventive diagnosis apparatus for substation equipment, which includes a data collection module, a user interface, a database, and a processor operatively coupled to the data collection module, the user interface, and the database, wherein the processor stores complex data of substation equipment collected through the data collection module in the database, comprehensively determines a state of the substation equipment to provide a diagnosis result and history information, determines a partial discharge state using a partial discharge state determination algorithm on the basis of partial discharge data of the substation equipment, determines an insulation degradation state of the substation equipment using an insulation degradation state determination algorithm on the basis of insulation degradation data, and provides a comprehensive diagnosis result through the user interface.

The data collection module may collect one or more of equipment information, Internet of things (IoT) sensor data, instantaneous data, diagnostic data, inspection data, failure data, monitoring data, and measurement data for the substation equipment in conjunction with a peripheral system.

The processor may apply weights on the basis of a state grade and operational data of the substation equipment to set an inspection priority and provide the set inspection priority through the user interface.

The processor may interactively provide a data linkage state of the collected data, fault management information, and equipment information through the user interface.

The processor may combine whether partial discharge occurs, an average size, a duration, an alarm occurrence frequency, an increase rate of the average size, and an increase rate of the duration to determine the partial discharge state.

The processor may determine whether there is a data error on the basis of change rates of a leakage current and electrostatic capacity on the basis of the insulation degradation data, then compare a %power factor (%PF) value with a reference value according to an insulation degradation determination item, and determine an increase rate of a Watt Loss value relative to the reference value and an increase rate of the Watt Loss value relative to a previously measured value to determine the insulation degradation state.

According to an aspect of the present invention, there is provided a preventive diagnostic method for substation equipment, which includes collecting, by a processor, complex data of substation equipment through a data collection module, storing, by the processor, the collected complex data in a database, comprehensively determining, by the processor, a state of the substation equipment on the basis of the complex data and providing a diagnosis result and history information, determining, by the processor, a partial discharge state using a partial discharge state determination algorithm on the basis of partial discharge data of the substation equipment, determining, by the processor, an insulation degradation state of the substation equipment using an insulation degradation state determination algorithm on the basis of insulation degradation data, and providing, by the processor, a comprehensive diagnosis result through a user interface.

In the collecting of the complex data, the processor may collect one or more of equipment information, Internet of things (IoT) sensor data, instantaneous data, diagnostic data, inspection data, failure data, monitoring data, and measurement data for the substation equipment in conjunction with a peripheral system through the data collection module.

In the providing of the diagnosis result and the history information, the processor may apply weights on the basis of a state grade and operational data of the substation equipment to set an inspection priority and provide the set inspection priority through the user interface.

In the providing of the comprehensive diagnosis result through the user interface, the processor may interactively provide a data linkage state of the collected data, fault management information, and equipment information through the user interface.

In the determining of the partial discharge state, the processor may combine whether partial discharge occurs, an average size, a duration, an alarm occurrence frequency, an increase rate of the average size, and an increase rate of the duration to determine the partial discharge state.

In the determining of the insulation degradation state, the processor may determine whether there is a data error on the basis of change rates of a leakage current and electrostatic capacity on the basis of the insulation degradation data, then compare a %PF value with a reference value according to an insulation degradation determination item, and determines an increase rate of a Watt Loss value relative to the reference value and an increase rate of the Watt Loss value relative to a previously measured value to determine the insulation degradation state.

### BRIEF DESCRIPTION OF THE DRAWINGS

The above and other objects, features and advantages of the present invention will become more apparent to those of ordinary skill in the art by describing exemplary embodiments thereof in detail with reference to the accompanying drawings, in which:
FIG. 1 is a block diagram illustrating a preventive diagnosis apparatus for substation equipment according to an embodiment of the present invention;
FIG. 2 shows graphs of an average size and duration of partial discharge in the preventive diagnosis apparatus for substation equipment according to an embodiment of the present invention;
FIG. 3 is a diagram showing an average size in the case of partial discharge defect in the preventive diagnosis apparatus for substation equipment according to an embodiment of the present invention;
FIG. 4 is a diagram showing a duration in the case of partial discharge defect in the preventive diagnosis apparatus for substation equipment according to an embodiment of the present invention;
FIG. 5 is an example of a partial discharge state grade table in the preventive diagnosis apparatus for substation equipment according to an embodiment of the present invention;
FIG. 6 is a table showing %power factor (%PF) reference values according to insulation degradation determination items in the preventive diagnosis apparatus for substation equipment according to an embodiment of the present invention;
FIG. 7 is a table showing criteria for determining an increase rate compared to an insulation degradation Watt Loss reference value in the preventive diagnosis apparatus for substation equipment according to an embodiment of the present invention;
FIG. 8 is a table showing criteria for determining an increase rate compared to a previous value of insulation degradation Watt Loss in the preventive diagnosis apparatus for substation equipment according to an embodiment of the present invention; and
FIG. 9 is a flowchart for describing a preventive diagnostic method for substation equipment according to an embodiment of the present invention.

### DETAILED DESCRIPTION OF EXEMPLARY EMBODIMENTS

The components described in the example embodiments may be implemented by hardware components including, for example, at least one digital signal processor (DSP), a processor, a controller, an application-specific integrated circuit (ASIC), a programmable logic element, such as an FPGA, other electronic devices, or combinations thereof. At least some of the functions or the processes described in the example embodiments may be implemented by software, and the software may be recorded on a recording medium. The components, the functions, and the processes described in the example embodiments may be implemented by a combination of hardware and software.

The method according to example embodiments may be embodied as a program that is executable by a computer, and may be implemented as various recording media such as a magnetic storage medium, an optical reading medium, and a digital storage medium.

Various techniques described herein may be implemented as digital electronic circuitry, or as computer hardware, firmware, software, or combinations thereof. The techniques may be implemented as a computer program product, i.e., a computer program tangibly embodied in an information carrier, e.g., in a machine-readable storage device (for example, a computer-readable medium) or in a propagated signal for processing by, or to control an operation of a data processing apparatus, e.g., a programmable processor, a computer, or multiple computers. A computer program(s) may be written in any form of a programming language, including compiled or interpreted languages and may be deployed in any form including a stand-alone program or a module, a component, a subroutine, or other units suitable for use in a computing environment. A computer program may be deployed to be executed on one computer or on multiple computers at one site or distributed across multiple sites and interconnected by a communication network.

Processors suitable for execution of a computer program include, by way of example, both general and special purpose microprocessors, and any one or more processors of any kind of digital computer. Generally, a processor will receive instructions and data from a read-only memory or a random access memory or both. Elements of a computer may include at least one processor to execute instructions and one or more memory devices to store instructions and data. Generally, a computer will also include or be coupled to receive data from, transfer data to, or perform both on one or more mass storage devices to store data, e.g., magnetic, magneto-optical disks, or optical disks. Examples of information carriers suitable for embodying computer program instructions and data include semiconductor memory devices, for example, magnetic media such as a hard disk, a floppy disk, and a magnetic tape, optical media such as a compact disk read only memory (CD-ROM), a digital video disk (DVD), etc. and magneto-optical media such as a floptical disk, and a read only memory (ROM), a random access memory (RAM), a flash memory, an erasable programmable ROM (EPROM), and an electrically erasable programmable ROM (EEPROM) and any other known computer readable medium. A processor and a memory may be supplemented by, or integrated into, a special purpose logic circuit.

The processor may run an operating system (OS) and one or more software applications that run on the OS. The processor device also may access, store, manipulate, process, and create data in response to execution of the software. For purpose of simplicity, the description of a processor device is used as singular; however, one skilled in the art will be appreciated that a processor device may include multiple processing elements and/or multiple types of processing elements. For example, a processor device may include multiple processors or a processor and a controller. In addition, different processing configurations are possible, such as parallel processors.

Also, non-transitory computer-readable media may be any available media that may be accessed by a computer, and may include both computer storage media and transmission media.

The present specification includes details of a number of specific implements, but it should be understood that the details do not limit any invention or what is claimable in the specification but rather describe features of the specific example embodiment. Features described in the specification in the context of individual example embodiments may be implemented as a combination in a single example embodiment. In contrast, various features described in the specification in the context of a single example embodiment may be implemented in multiple example embodiments individually or in an appropriate sub-combination. Furthermore, the features may operate in a specific combination and may be initially described as claimed in the combination, but one or more features may be excluded from the claimed combination in some cases, and the claimed combination may be changed into a sub-combination or a modification of a sub-combination.

Similarly, even though operations are described in a specific order on the drawings, it should not be understood as the operations needing to be performed in the specific order or in sequence to obtain desired results or as all the operations needing to be performed. In a specific case, multitasking and parallel processing may be advantageous. In addition, it should not be understood as requiring a separation of various apparatus components in the above described example embodiments in all example embodiments, and it should be understood that the above-described program components and apparatuses may be incorporated into a single software product or may be packaged in multiple software products.

It should be understood that the example embodiments disclosed herein are merely illustrative and are not intended to limit the scope of the invention. It will be apparent to one of ordinary skill in the art that various modifications of the example embodiments may be made without departing from the spirit and scope of the claims and their equivalents.

Hereinafter, with reference to the accompanying drawings, embodiments of the present disclosure will be described in detail so that a person skilled in the art can readily carry out the present disclosure. However, the present disclosure may be embodied in many different forms and is not limited to the embodiments described herein.

In the following description of the embodiments of the present disclosure, a detailed description of known functions and configurations incorporated herein will be omitted when it may make the subject matter of the present disclosure rather unclear. Parts not related to the description of the present disclosure in the drawings are omitted, and like parts are denoted by similar reference numerals.

In the present disclosure, components that are distinguished from each other are intended to clearly illustrate each feature. However, it does not necessarily mean that the components are separate. That is, a plurality of components may be integrated into one hardware or software unit, or a single component may be distributed into a plurality of hardware or software units. Thus, unless otherwise noted, such integrated or distributed embodiments are also included within the scope of the present disclosure.

In the present disclosure, components described in the various embodiments are not necessarily essential components, and some may be optional components. Accordingly, embodiments consisting of a subset of the components described in one embodiment are also included within the scope of the present disclosure. In addition, embodiments that include other components in addition to the components described in the various embodiments are also included in the scope of the present disclosure.

Hereinafter, with reference to the accompanying drawings, embodiments of the present disclosure will be described in detail so that a person skilled in the art can readily carry out the present disclosure. However, the present disclosure may be embodied in many different forms and is not limited to the embodiments described herein.

In the following description of the embodiments of the present disclosure, a detailed description of known functions and configurations incorporated herein will be omitted when it may make the subject matter of the present disclosure rather unclear. Parts not related to the description of the present disclosure in the drawings are omitted, and like parts are denoted by similar reference numerals.

In the present disclosure, when a component is referred to as being "linked," "coupled," or "connected" to another component, it is understood that not only a direct connection relationship but also an indirect connection relationship through an intermediate component may also be included. In addition, when a component is referred to as "comprising" or "having" another component, it may mean further inclusion of another component not the exclusion thereof, unless explicitly described to the contrary.

In the present disclosure, the terms first, second, etc. are used only for the purpose of distinguishing one component from another, and do not limit the order or importance of components, etc., unless specifically stated otherwise. Thus, within the scope of this disclosure, a first component in one exemplary embodiment may be referred to as a second component in another embodiment, and similarly a second component in one exemplary embodiment may be referred to as a first component.

In the present disclosure, components that are distinguished from each other are intended to clearly illustrate each feature. However, it does not necessarily mean that the components are separate. That is, a plurality of components may be integrated into one hardware or software unit, or a single component may be distributed into a plurality of hardware or software units. Thus, unless otherwise noted, such integrated or distributed embodiments are also included within the scope of the present disclosure.

In the present disclosure, components described in the various embodiments are not necessarily essential components, and some may be optional components. Accordingly, embodiments consisting of a subset of the components described in one embodiment are also included within the scope of the present disclosure. In addition, exemplary embodiments that include other components in addition to the components described in the various embodiments are also included in the scope of the present disclosure.

Hereinafter, a preventive diagnosis apparatus and method for substation equipment according to embodiments of the present invention will be described.

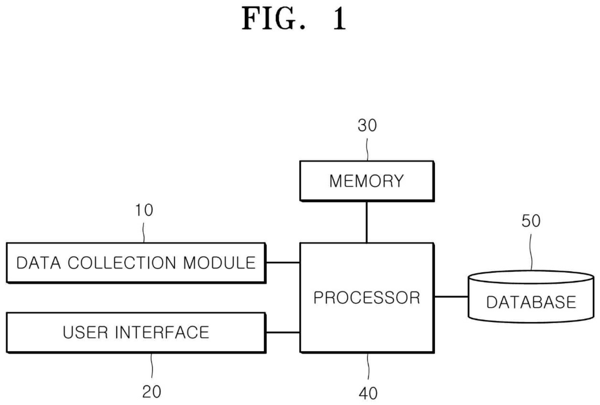

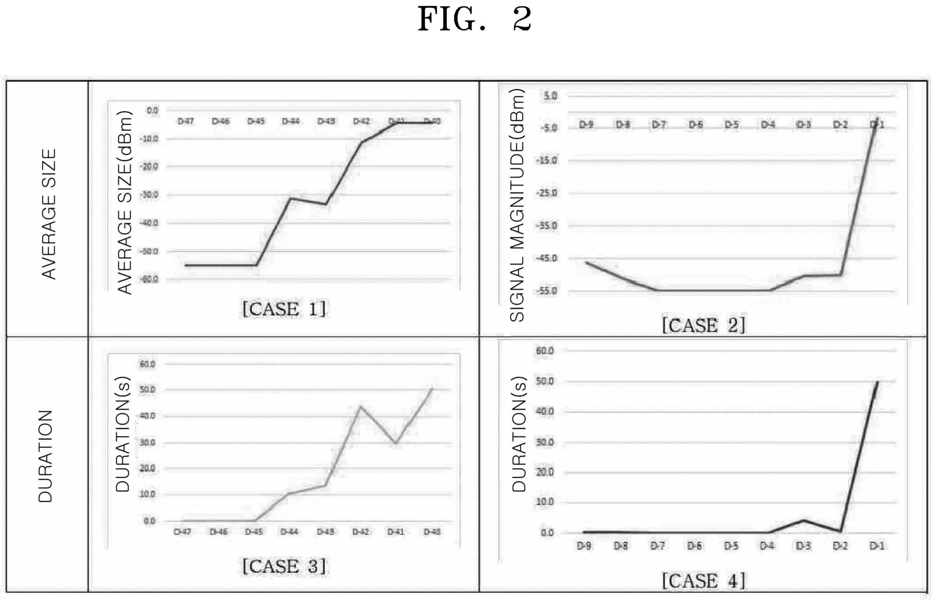

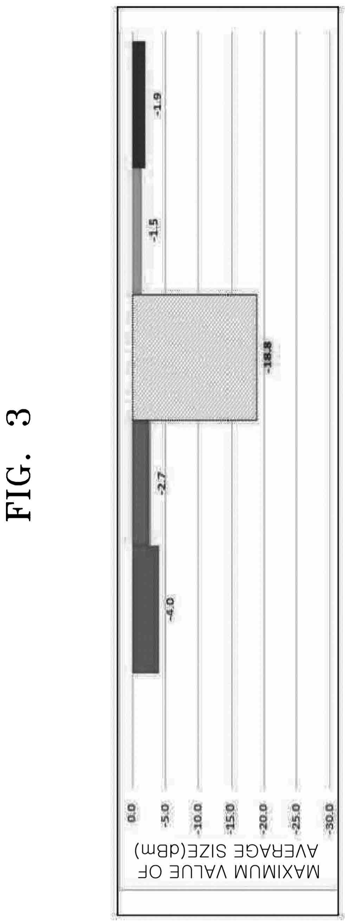

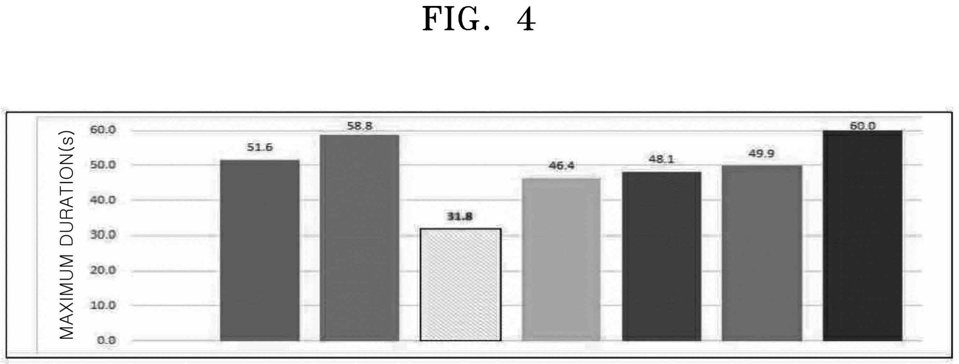

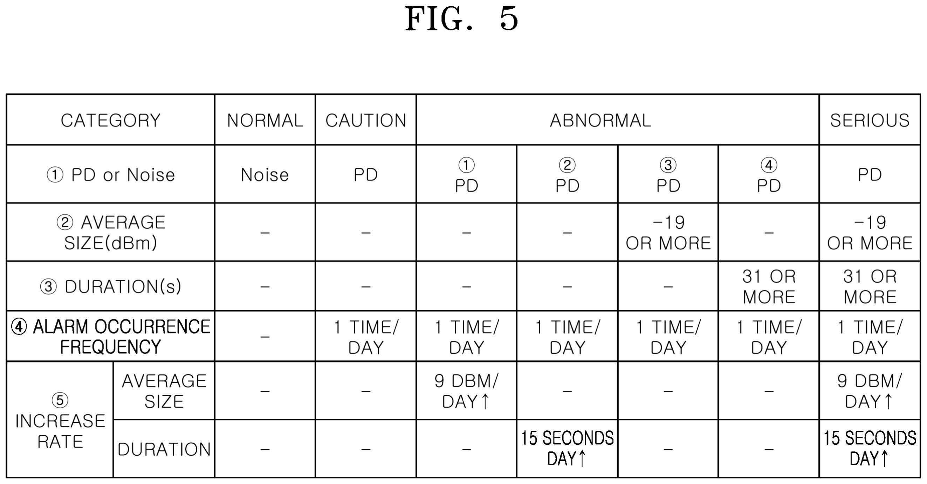

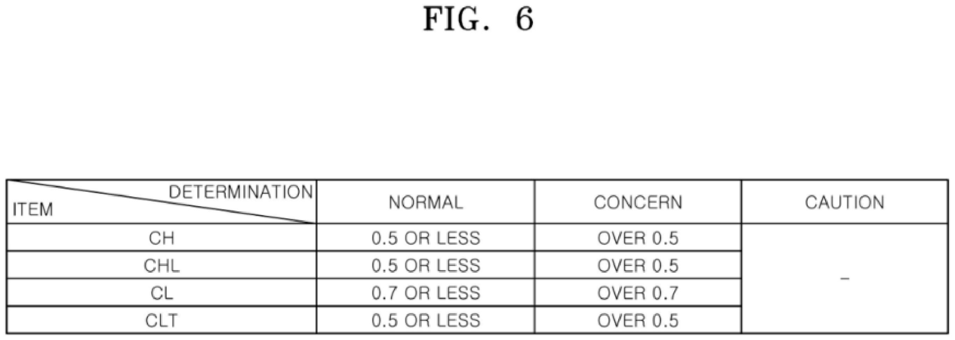

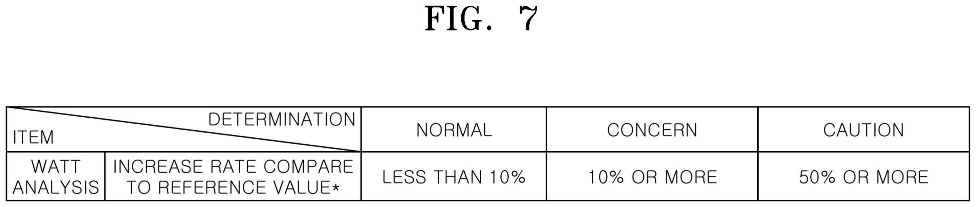

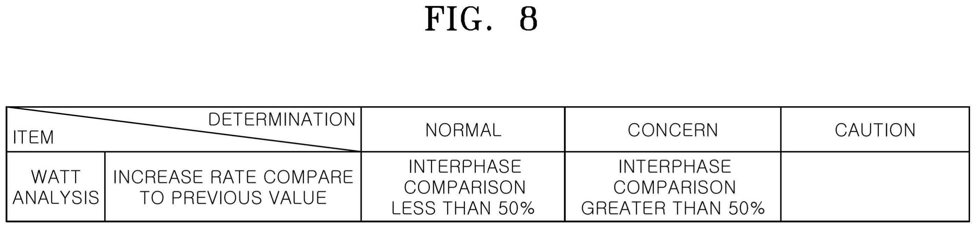

FIG. 1 is a block diagram illustrating a preventive diagnosis apparatus for substation equipment according to an embodiment of the present invention, FIG. 2 shows graphs of the average size and duration of partial discharge in the preventive diagnosis apparatus for substation equipment according to an embodiment of the present invention, FIG. 3 is a diagram showing an average size in the case of partial discharge defect in the preventive diagnosis apparatus for substation equipment according to an embodiment of the present invention, FIG. 4 is a diagram showing a duration in the case of partial discharge defect in the preventive diagnosis apparatus for substation equipment according to an embodiment of the present invention, FIG. 5 is an example of a partial discharge state grade table in the preventive diagnosis apparatus for substation equipment according to an embodiment of the present invention, FIG. 6 is a table showing %power factor (%PF) reference values according to insulation degradation determination items in the preventive diagnosis apparatus for substation equipment according to an embodiment of the present invention, FIG. 7 is a table showing criteria for determining an increase rate compared to an insulation degradation Watt Loss reference value in the preventive diagnosis apparatus for substation equipment according to an embodiment of the present invention, and FIG. 8 is a table showing criteria for determining an increase rate compared to a previous value of insulation degradation Watt Loss in the preventive diagnosis apparatus for substation equipment according to an embodiment of the present invention.

As illustrated in FIG. 1, the preventive diagnosis apparatus for substation equipment according to an embodiment of the present invention may include a data collection module 10, a user interface 20, a memory 30, a processor 40, and a database 50.

The data collection module 10 may collect one or more of equipment information, Internet of things (IoT) sensor data, instantaneous data, diagnostic data, inspection data, failure data, monitoring data, and measurement data for substation equipment in conjunction with a peripheral system.

For example, the data collection module 10 may be linked with peripheral systems, such as IoT gateways and sensor networks, a supervisory control and data acquisition (SCADA) system, a dedicated sensor module, a distributed control system (DCS), a substation total operation management (STOM) system, a maintenance history management system, etc., using protocols such as message queuing telemetry transport (MQTT), open platform communications unified architecture (OPC-UA), International Electrotechnical Commission (IEC) 61850, etc.

The user interface 20 is a device for interacting with a user and may provide user interface/user experience (UI/UX).

That is, the user interface 20 may include a plurality of input units for inputting data into the preventive diagnosis apparatus for substation equipment and interactively searching and selecting the substation equipment and include a plurality of output units for providing comprehensive diagnosis results, such as a partial discharge state, an insulation degradation state, etc., in addition to diagnosis results and history information.

The plurality of input units may include keyboards, touch screens, Universal Serial Bus (USB) devices, communication devices, and the like for data (information) input. Further, the plurality of output units may include speakers, displays, and the like.

The database 50 may store complex data collected through the data collection module 10 and store the comprehensive diagnosis results.

The memory 30 may store various types of data used by the processor 40. The data may include instructions for performing operations or steps according to embodiments of the present invention. That is, the memory 30 may store instructions for performing functions of a data hub.

Further, the memory 30 may store data required for operations or steps performed according to the above-described instructions or store data generated through the operations or steps.

The memory 30 may include at least one storage medium among a flash memory type memory, a hard disk type memory, a multimedia card micro type memory, a card type memory, a random access memory (RAM), a static RAM (SRAM), a read-only memory (ROM), a programmable ROM (PROM), an erasable programmable ROM (EPROM), and an electrically erasable programmable ROM (EEPROM).

The memory 30 may include a magnetic storage medium or a flash storage medium in addition to a volatile storage device that requires power to maintain stored information, but the scope of the present invention is not limited thereto.

The processor 40 may be operatively coupled to the data collection module 10, the user interface 20, the memory 30, and the database 50 and may execute the instructions stored in the memory 30 to perform various types of operations and store generated data in order to control the overall operation of the preventive diagnosis apparatus for substation equipment.

Further, the processor 40 is a component for performing each function and may be separately configured at the hardware, software, or logic level. In this case, dedicated hardware may be used to perform each function. To this end, the processor 40 may be implemented as or include at least one of an application specific integrated circuit (ASIC), a digital signal processor (DSP), programmable logic devices (PLDs), field programmable gate arrays (FPGAs), a central processing unit (CPU), microcontrollers, and/or microprocessors.

The processor 40 may be implemented as a CPU or a system on chip (SoC), control a plurality of hardware or software components connected to the processor 40 by running an operating system or application, and perform various data processing and operations.

First, the processor 40 may run an execution program stored in the memory 30, then collect complex data of the substation equipment in conjunction with a peripheral system through the data collection module 10, and store the collected complex data in the database 50.

The processor 40 may provide the complex data, which is collected to continuously manage the accuracy of substation equipment data, through the user interface 20 to monitor the complex data and may interactively provide diagnosis results and history information obtained by comprehensively determining a state of the substation equipment through the user interface 20.

Further, the processor 40 may apply a user-centered UI/UX to interactively provide a data linkage state of the data collected through the user interface, fault management information, and equipment information, through the user interface 20.

In addition, the processor 40 may manage defect signals and equipment failure history, set alarms and event conditions according to state determination results, analyze trends such as alarm occurrence history for each equipment, and generate reports to provide the generated reports to users.

Meanwhile, the processor 40 may provide information on a sensor which does not generate an alarm for a long period of time to detect abnormalities in the sensor or device.

In this way, the processor 40 may prevent and diagnose failures of a plurality of pieces of substation equipment, such as a gas insulated switchgear (GIS), a shunt reactor (Sh.R), a vacuum circuit breakers (VCB), a potential transformer (PT), a neutral grounding resistance (NGR), and the like of 23 kV class with a high frequency of failures, in addition to transformers and GIS of 154 kV or higher, and provide results of the diagnosis.

Further, the processor 40 may apply weights on the basis of a state grade and operational data of the substation equipment to set an inspection priority and provide the set inspection priority through the user interface 20, thereby reducing dependence on the determination of field operators and enabling efficient maintenance through planned maintenance.

The processor 40 may combine whether partial discharge occurs, an average size, a duration, an alarm occurrence frequency, an average size increase rate, and a duration increase rate using a partial discharge state determination algorithm on the basis of partial discharge data of the substation equipment to determine a partial discharge state when the result of the combination exceeds reference values.

In the present embodiment, the reference values for the average size and duration may be set by analyzing the trends in the partial discharge data.

That is, as illustrated in FIG. 2, the trends in the partial discharge data show a sharp increase in the average size and duration.

Therefore, in the present embodiment, a threshold value of the average size may be set when a partial discharge occurs by utilizing data on a case in which a partial discharge defect has occurred.

For example, as a result of analyzing the trends of a maximum average size of partial discharge in equipment in which partial discharge has occurred as illustrated in FIG. 3, the threshold value may be set to -19 dBm in the present embodiment.

Further, as a result of analyzing the trends of a maximum duration of partial discharge in equipment in which the occurrence of partial discharge has been confirmed, the maximum value is confirmed to be 60 seconds as illustrated in FIG. 4, and thus, when the duration of partial discharge lasts for 31 seconds or more, the threshold value may be set due to an increased risk of failure.

In addition, for example, by analyzing an average, a standard deviation, a maximum value, and a minimum value of changes in average size of the 14-day period in a case in which partial discharge has occurred compared to those in a previous period, minimum values among cases of sudden increase may be set as reference values for the average size increase rate and duration increase rate of partial discharge. In the present embodiment, a reference value for the average size increase rate was set to +9 dBm, and a reference value for the duration increase rate was set to +15 seconds.

Further, a reference value for the alarm occurrence frequency may be set to one alarm per 24 hours by applying determination criteria within the purchase specifications of a GIS partial discharge diagnosis system.

Therefore, in the present embodiment, the processor 40 may combine cases depending on each of whether the partial discharge occurs, the average size, the duration, the alarm occurrence frequency, the average size increase rate, and the duration increase rate exceeds the reference value, as shown in FIG. 5, to determine the partial discharge state as normal, caution, abnormal, or serious.

In addition, the processor 40 may determine an insulation degradation state of the substation equipment using an insulation degradation state determination algorithm on the basis of insulation degradation data and provide a comprehensive diagnosis result through the user interface.

That is, the processor 40 may determine whether there is a data error on the basis of change rates of a leakage current and electrostatic capacity on the basis of the degradation data, then compare a %PF value with a reference value according to an insulation degradation determination item, and determine an increase rate of a Watt Loss value relative to the reference value and an increase rate of the Watt Loss value relative to a previously measured value to determine the insulation degradation state.

More specifically, the processor 40 may determine that there is a data error when change rates of the leakage current (mA) and electrostatic capacity (C) on the basis of the degradation data have changed by +3% or more relative to the previously measured value, and may stop the subsequent determination process.

After confirming the reliability of the degradation data in this way, the processor 40 may make a first-stage determination as "normal" and "concern" based on a %PF reference value for each measurement item of the insulation degradation data set as shown in FIG. 6.

For the equipment determined as "concern" in the first-stage determination, the processor 40 may make a second-stage determination as "normal," "concern," and "caution" based on an increase rate compared to a Watt Loss reference value set as shown in FIG. 7.

Here, since the Watt Loss reference value is not specified in the equipment specifications, the Watt Loss reference value may be set as in Equation 1 by utilizing a total leakage current value obtained when measuring insulation degradation. [Equation 1] $WattLoss reference value = % PF \left(BASE\right) reference value ∗ \frac{\left(leakage current \left(mA\right)∗0.97\right)}{10}$

In this case, a correction factor of 0.97 may be applied to the measured leakage current (mA) in consideration of the equipment degradation and measurement errors, and the reference value used in the first-stage determination may be applied as a %PF(Base) reference value.

Therefore, the processor 40 may perform the second-stage determination by calculating a Watt Loss increase rate as in Equation 2. [Equation 2] $WattLoss increase rateV = \left[\frac{WattLoss measured value}{WattLoss reference value}-1\right] * 100$

After making the second-stage determination in this way, the processor 40 may finally make a third-stage determination in which the insulation degradation state is determined as "normal" and "concern" on the basis of an increase rate compared to a previously measured Watt Loss value set as shown in FIG. 8.

In this case, the processor 40 may calculate a Watt Loss increase rate as in Equation 3 using a most recently measured Watt Loss value and an immediately previously measured Watt Loss value, and then calculate an increase rate between phases A, B, and C of the same equipment as in Equation 4 to compensate for changes in data due to environmental factors such as temperature, humidity, etc., thereby determining a third-stage insulation degradation state. [Equation 3] $WattLoss increase rateV = \left[\frac{Recently measured WattLoss value - Immediately previously measured WattLoss value}{Immediately previously measured WattLoss value}\right] \times 100$ [Equation 4] $Interphase comparison = 3 - phase Max \left(WattLoss increase rate\right) - Min \left(WattLoss increase rate\right)$

Therefore, the processor 40 may finally classify the stage into "data error," "normal," "concern," and "caution" stages and provide the insulation degradation state through the user interface 20 by utilizing insulation degradation measurement data.

As described above, according to the preventive diagnosis apparatus for substation equipment according to the embodiment of the present invention, an abnormal sign of equipment can be more precisely determined based on a state determination algorithm in which maintenance and operation data are combined in addition to sensor data of substation equipment, thereby encompassing not only preventive diagnosis but also the maintenance and repair work and increasing the accuracy of prediction and the field usability.

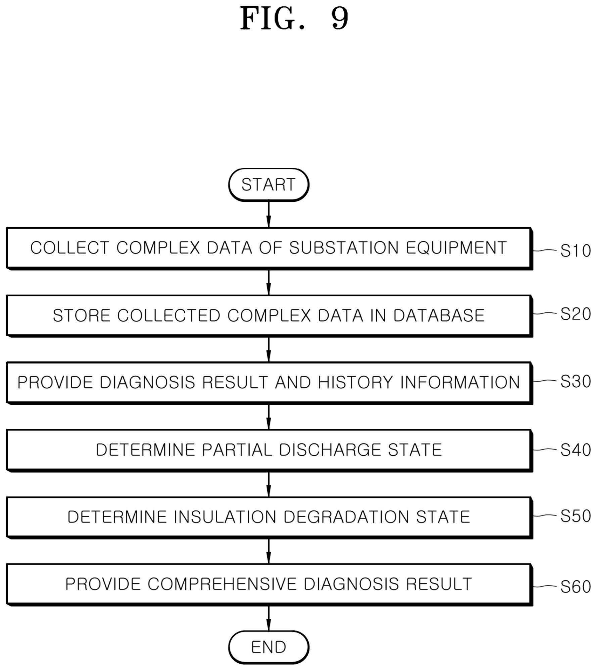

FIG. 9 is a flowchart for describing a preventive diagnostic method for substation equipment according to an embodiment of the present invention.

As illustrated in FIG. 9, in the preventive diagnostic method for substation equipment according to an embodiment of the present invention, a processor 40 runs an execution program stored in a memory 30 first and then collects complex data of substation equipment in conjunction with a peripheral system through a data collection module 10 (S10).

The processor 40 may collect one or more of equipment information, IoT sensor data, instantaneous data, diagnostic data, inspection data, failure data, monitoring data, and measurement data for substation equipment in conjunction with a peripheral system through the data collection module 10.

In operation S10, after collecting the complex data of the substation equipment, the processor 40 stores the collected complex data in a database 50 (S20).

In operation S10, while collecting the IoT sensor data, the instantaneous data, the diagnostic data, the inspection data, the failure data, the monitoring data and the measurement data for the substation equipment, the processor 40 not only provides the collected data through a user interface 20 to continuously manage the accuracy of the substation equipment data, but also provides diagnosis results and history information (S30).

In this case, the processor 40 may apply weights on the basis of a state grade and operational data of the substation equipment to set an inspection priority and provide the set inspection priority through the user interface 20, thereby reducing dependence on the determination of field operators and enabling efficient maintenance through planned maintenance.

In addition, the processor 40 determines a partial discharge state using a partial discharge state determination algorithm on the basis of partial discharge data of the substation equipment (S40).

Here, the processor 40 may combine whether partial discharge occurs, an average size, a duration, an alarm occurrence frequency, an average size increase rate, and a duration increase rate using a partial discharge state determination algorithm on the basis of partial discharge data of the substation equipment to determine a partial discharge state when results of the combination exceed reference values.

In the present embodiment, the reference values for the average size and duration may be set by analyzing the trends in the partial discharge data.

Therefore, in the present embodiment, the processor 40 may combine cases depending on each of whether the partial discharge occurs, the average size, the duration, the alarm occurrence frequency, the average size increase rate, and the duration increase rate exceeds the reference value, as shown in FIG. 5, to determine the partial discharge state as normal, caution, abnormal, or serious.

Further, the processor 40 determines an insulation degradation state of the substation equipment using an insulation degradation state determination algorithm on the basis of insulation degradation data (S50).

That is, the processor 40 determines whether there is a data error on the basis of change rates of a leakage current and electrostatic capacity on the basis of the degradation data, then, in a first stage, compares a %PF value with a reference value according to an insulation degradation determination item to determine "normal" and "concern" targets, in a second stage, determines an increase rate of a Watt Loss value relative to a reference value to determine "normal," "concern," and "caution" targets, in a third stage, determines an increase rate of the Watt Loss value relative to a previously measured value to determine "normal" and "concern" targets, and finally classifies the stage into "data error," "normal," "concern," and "caution" stages by utilizing insulation degradation measurement data.

After determining the partial discharge state and the insulation degradation state in this way, the processor 40 provides a comprehensive diagnosis result through the user interface 20 (S60).

Further, the processor 40 may apply a user-centered UI/UX to interactively provide a data linkage state of the data collected through the user interface, fault management information, and equipment information, through the user interface 20.

In addition, the processor 40 may manage defect signals and equipment failure history, set alarms and event conditions according to state determination results, analyze trends such as alarm occurrence history for each equipment, and generate reports to provide the generated reports to users.

In this way, the processor 40 may prevent and diagnose failures of a plurality of pieces of substation equipment, such as a GIS, a Sh.R, a VCB, a PT, and a NGR of 23 kV class with a high frequency of failures, in addition to transformers and GIS of 154 kV or higher, and provide results of the diagnosis.

As described above, according to the preventive diagnostic method for substation equipment according to the embodiment of the present invention, an abnormal sign of equipment can be more precisely determined based on a state determination algorithm in which maintenance and operation data are combined in addition to sensor data of substation equipment thereby encompassing not only preventive diagnosis but also the maintenance and repair work and increasing the accuracy of prediction and the field usability.

According to the preventive diagnosis apparatus and method for substation equipment according to an aspect of the present invention, an abnormal sign of equipment can be more precisely determined based on a state determination algorithm in which maintenance and operation data are combined in addition to sensor data of substation equipment, thereby encompassing not only preventive diagnosis but also the maintenance and repair work and increasing the accuracy of prediction and the field usability.

## Claims

1. A preventive diagnosis apparatus for substation equipment, the preventive diagnosis apparatus comprising:
a data collection module;
a user interface;
a database; and
a processor operatively coupled to the data collection module, the user interface, and the database,
wherein the processor stores complex data of substation equipment collected through the data collection module in the database, comprehensively determines a state of the substation equipment to provide a diagnosis result and history information, determines a partial discharge state using a partial discharge state determination algorithm on the basis of partial discharge data of the substation equipment, determines an insulation degradation state of the substation equipment using an insulation degradation state determination algorithm on the basis of insulation degradation data, and provides a comprehensive diagnosis result through the user interface.

2. The preventive diagnosis apparatus of claim 1, wherein the data collection module collects one or more of equipment information, Internet of things (IoT) sensor data, instantaneous data, diagnostic data, inspection data, failure data, monitoring data, and measurement data for the substation equipment in conjunction with a peripheral system.

3. The preventive diagnosis apparatus of claim 1, wherein the processor applies weights on the basis of a state grade and operational data of the substation equipment to set an inspection priority and provide the set inspection priority through the user interface.

4. The preventive diagnosis apparatus of claim 1, wherein the processor interactively provides a data linkage state of the collected data, fault management information, and equipment information through the user interface.

5. The preventive diagnosis apparatus of claim 1, wherein the processor combines whether partial discharge occurs, an average size, a duration, an alarm occurrence frequency, an increase rate of the average size, and an increase rate of the duration to determine the partial discharge state.

6. The preventive diagnosis apparatus of claim 1, wherein the processor determines whether there is a data error on the basis of change rates of a leakage current and electrostatic capacity on the basis of the insulation degradation data, then compares a %power factor (%PF) value with a reference value according to an insulation degradation determination item, and determines an increase rate of a Watt Loss value relative to the reference value and an increase rate of the Watt Loss value relative to a previously measured value to determine the insulation degradation state.

7. A preventive diagnostic method for substation equipment, the preventive diagnostic method comprising:
collecting, by a processor, complex data of substation equipment through a data collection module;
storing, by the processor, the collected complex data in a database;
comprehensively determining, by the processor, a state of the substation equipment on the basis of the complex data and providing a diagnosis result and history information;
determining, by the processor, a partial discharge state using a partial discharge state determination algorithm on the basis of partial discharge data of the substation equipment;
determining, by the processor, an insulation degradation state of the substation equipment using an insulation degradation state determination algorithm on the basis of insulation degradation data; and
providing, by the processor, a comprehensive diagnosis result through a user interface.

8. The preventive diagnosis method of claim 7, wherein, in the collecting of the complex data, the processor collects one or more of equipment information, Internet of things (IoT) sensor data, instantaneous data, diagnostic data, inspection data, failure data, monitoring data, and measurement data for the substation equipment in conjunction with a peripheral system through the data collection module.

9. The preventive diagnosis method of claim 7, wherein, in the providing of the diagnosis result and the history information, the processor applies weights on the basis of a state grade and operational data of the substation equipment to set an inspection priority and provide the set inspection priority through the user interface.

10. The preventive diagnosis method of claim 7, wherein, in the providing of the comprehensive diagnosis result through the user interface, the processor interactively provides a data linkage state of the collected data, fault management information, and equipment information through the user interface.

11. The preventive diagnosis method of claim 7, wherein, in the determining of the partial discharge state, the processor combines whether partial discharge occurs, an average size, a duration, an alarm occurrence frequency, an increase rate of the average size, and an increase rate of the duration to determine the partial discharge state.

12. The preventive diagnosis method of claim 7, wherein, in the determining of the insulation degradation state, the processor determines whether there is a data error on the basis of change rates of a leakage current and electrostatic capacity on the basis of the insulation degradation data, then compares a %power factor (%PF) value with a reference value according to an insulation degradation determination item, and determines an increase rate of a Watt Loss value relative to the reference value and an increase rate of the Watt Loss value relative to a previously measured value to determine the insulation degradation state.
